Europäisches Patentamt

European Patent Office

Office européen des brevets

(11) Publication number: **0 070 737**
**B1**

(12) **EUROPEAN PATENT SPECIFICATION**

(45) Date of publication of patent specification: **01.10.86**

(51) Int. Cl.⁴: **H 01 L 23/48,** H 01 L 21/60

(21) Application number: **82303828.6**

(22) Date of filing: **21.07.82**

(54) **Semiconductor device having an electrode, and method for producing the same.**

(30) Priority: **21.07.81 JP 114716/81**

(43) Date of publication of application:
**26.01.83 Bulletin 83/04**

(45) Publication of the grant of the patent:
**01.10.86 Bulletin 86/40**

(84) Designated Contracting States:
**DE FR GB**

(56) References cited:
**DE-A-1 806 980**
**US-A-4 163 246**
**US-A-4 164 461**

**IBM TECHNICAL DISCLOSURE BULLETIN, vol.**
**21, no. 3, August 1978, pages 1052-1053, New**
**York, US, J. GNIEWEK et al.: "Dual insulators**
**for planar multilevel interconnections"**

(73) Proprietor: **FUJITSU LIMITED**
**1015, Kamikodanaka Nakahara-ku**
**Kawasaki-shi Kanagawa 211 (JP)**

(72) Inventor: **Imaoka, Kazunori**
**Komae Haitaun 3-304 17, Higashinogawa 3-**
**chome**
**Komae-shi Tokyo 201 (JP)**

(74) Representative: **Skone James, Robert Edmund**
**et al**
**GILL JENNINGS & EVERY 53-64 Chancery Lane**
**London WC2A 1HN (GB)**

Courier Press, Leamington Spa, England.

## Description

The present invention relates to a semiconductor device and a method for producing the same. More particularly, it relates to an interconnection structure in a semiconductor device, such as an integrated circuit (IC) device or a large-scale integration (LSI) device.

In order to make a semiconductor device (an IC or LSI device) denser, active elements (e.g., transistors) and passive elements (e.g., resistors and condensers) in the semiconductor device are made smaller, and the conductor pattern for electrically interconnecting the elements is made finer. The conductor pattern comprises conductor lines (i.e., wirings) lying on an insulating layer of, e.g., phosphosilicate glass (PSG) or silicon dioxide ($SiO_2$) and making contact through small apertures (i.e., contact holes) in the insulating layer with the underlying device portion (e.g., a portion of the semiconductor substrate) or with the other underlying conductor line.

In a case where a conductive layer (e.g., an aluminum layer) is formed by a vacuum evaporaton method and is photoengraved to form a conductor pattern, i.e. a desired pattern of conductor lines, cracks form in the conductor line at the contact hole edge, and, as a result, breakage or disconnection of the conductor line can occur or the resistance value of the conductor line can increase.

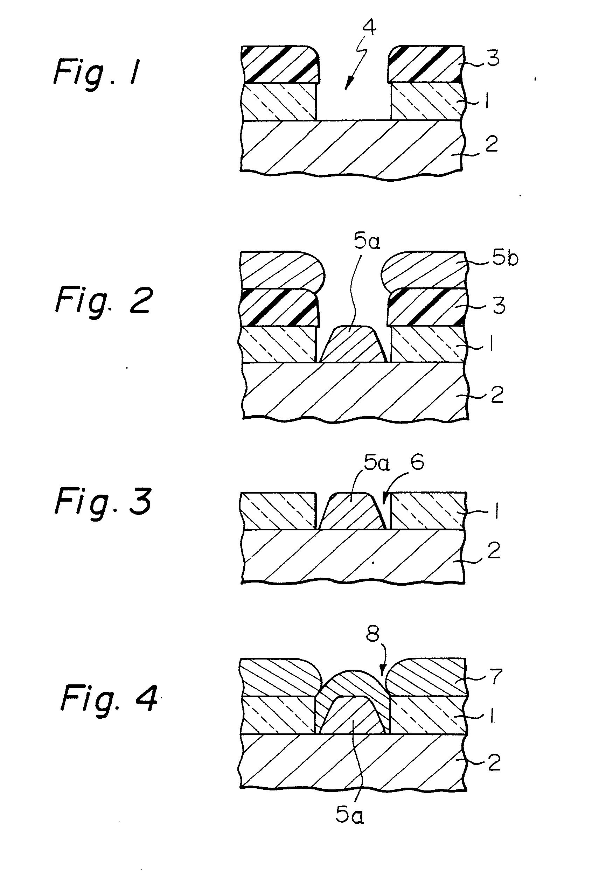

In order to form a conductor line without the above-mentioned disadvantage, it is attempted to round a relatively sharp edge of the contact hole by heating the insulating layer, consisting of, e.g., PSG, to its softening point. In this case, however, this heat treatment causes impurities doped in the diffused region of the semiconductor substrate to diffuse, and, thereby, the diffused region expands undesirably. It is also attempted to deposit conductive material (i.e., a contact electrode) in the contact hole only and then form the conductor line on the contact electrode and on the insulating layer. In the latter attempt, as illustrated in Fig. 1, an insulating layer 1 (e.g., PSG) formed on semiconductor substrate 2 (e.g., a silicon wafer) is selectively etched by a conventional photoetching method using photoresist layer 3 to form contact hole 4. As illustrated in Fig. 2, conductive material (e.g., aluminum) is deposited on photoresist layer 3 and the exposed surface of substrate 2 by a vacuum evaporation method to form contact electrode 5a and conductive layer 5b. Then, as illustrated in Fig. 3, photoresist layer 3 and conductive layer 5b are simultaneously removed with a suitable solvent. This removal process is referred to as the lift off process. Wedge gap 6 (Fig. 3) is formed between contact electrode 5a and the side of insulating layer 1. As illustrated in Fig. 4, when conductive material (e.g., aluminum) is deposited on insulating layer 1 and on contact electrode 5a by a vapour evaporation method to form conductor layer 7, cracks 8 form in conductor layer 7 depending on the circumstances. Accordingly, conductor layer 7 having cracks is patterned by a photoetching method to form a conductor line having a defect, such as a break or a thin portion. In this case, the possibility of the occurrence of breaks is not as great as in the case where a conductor line is formed without using a contact electrode.

IBM Technical Disclosure Bulletin, Vol. 21, No. 3, Aug. 1978, pages 1052—1053 describes a structure similar to the one shown in Fig. 3. The gaps between the sidewalls of the opening and the contact electrode are filled with an organic compound (polyimide).

In accordance with one aspect of the present invention, a semiconductor device comprises an insulating layer which is formed on a semiconductor substrate or a conductor line and is provided with a contact hole therein; a contact electrode formed in the contact hole; and a conductor line lying on the contact electrode and on the inslulating layer and is characterised in that a gap between the contact electrode and the side of the insulating layer is filled with an alloy of polycrystalline silicon and at least one of the conductor line lying on the contact electrode and the contact electrode.

With the invention a conductor line is formed without a break or a thin portion.

In accordance with another aspect of the present invention, a method of producing a semiconductor device comprises the steps of forming an insulating layer on a semiconductor substrate or a conductor line; opening a contact hole in the insulating layer; forming a contact electrode in the contact hole; and forming a conductor line on the contact electrode and insulating layer and is characterised in that the method further comprises the steps of filling a gap between the contact electrode and the side of the insulating layer with polycrystalline silicon prior to the formation of the conductor line; and alloying the polycrystalline silicon with at least one of the conductor line formed on the contact electrode and the contact electrode, by heating.

In one example using this method, the contact electrode may be arranged on another conductor line instead of a semiconductor substrate.

An example of a prior art device and method, and some examples of devices and methods in accordance with the present invention are illustrated in the accompanying drawings, in which:—

Figures 1 to 4 are partial cross-sectional views of a semiconductor device in various stages of production in accordance with a known method;

Figures 5 to 8 are partial cross-sectional views of one example of a semiconductor device in various stages of production in accordance with the present invention;

Figures 9 and 10 are partial cross-sectional views of a second example of a semiconductor device in various stages of production; and,

Figures 11 and 12 are partial cross-sectional views of a third example of a smeiconductor device in various stages of production.

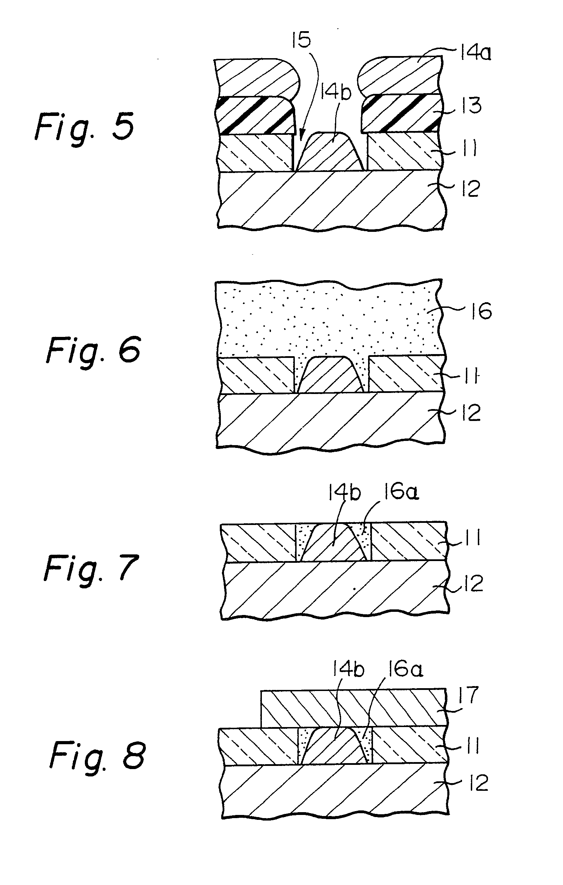

As illustrated in Figure 5, an insulating layer 11 (e.g. PSG or $SiO_2$) is formed on a semiconductor substrate 12 (e.g. a silicon wafer). A photoresist layer 13 is coated on insulating layer 11, is exposed, and is developed to form a photoresist pattern having a through hole. Insulating layer 11 is selectively etched with a suitable etchant through the through hole to form a contact hole (i.e., a through aperture). Then a high-melting point metal, such as molybdenum (Mo), tantalum (Ta), titanium (Ti), tungsten (W), or platinum (Pt), is deposited on photoresist layer 13 and on the exposed portion of semiconductor substrate 12 by a sputtering method to form metal layer 14a and contact electrode 14b. It is possible to use a silicide of one of the above-mentioned metals ($MoSi_2$, $TaSi_2$, TiSi, $WSi_2$, and $Pt_2Si$) instead of a high-melting point metal. It is preferable to make the thickness of metal layer 14a equal to that of insulating layer 11. Contact electrode 14b is positioned within the contact hole of insualting layer 11, and wedge gap 15 is formed between contact electrode 14b and the side of insulating layer 11.

Photoresist layer 13 is removed with a suitable solvent, and, therefore, metal layer 14a can be removed. Then, as illustrated in Fig. 6, polycrystalline silicon is deposited on the surfaces of insulating layer 11 and contact electrode 14b by a low-pressure chemical vapour deposition (CVD) method to form polycrystalline silicon layer 16. In this case, the thermal decomposition of siline ($SiH_4$) or the reduction of $SiCl_4$ (or $SiH_2Cl_2$) with hydrogen is carried out at a reaction temperature of from 600°C to 700°C so that it is impossible to use aluminum (Al) for contact electrode 14b. Moreover, the wedge gap 15 can be completely filled with the polycrystalline silicon.

Polycrystalline silicon layer 16 is etched to expose the surface of insulating layer 11 by a dry etching method, such as a reactive sputter etching method, as illustrated in Fig. 7. If the thickness of contact electrode 14b is equal to that of insulating layer 11, the surface of contact electrode 14b is also exposed. Wedge-shaped polycrystalline silicon portion 16a remains in the wedge gap so that a substantially level surface of the entire layer comprising insulating layer 11, contact electrode 14b, and wedge polycrystalline silicon portion 16a can be obtained.

Then, as illustrated in Fig. 8, Al is deposited on the level surface (i.e., on the surface of insulating layer 11, wedge polycrystalline silicon portion 16a, and contact electrode 14b) by a vacuum evaporation method to form a conductor layer 17 without causing cracks to form. Conductor (Al) layer 17 is selectively etched by a conventional photoetching method to form a conductor line for interconnection. It is possible to use one of the above-mentioned high-melting point metals, such as Mo, Ta, Ti, W, or Pt, instead of Al. In this case, conductor layer 17 is formed by sputtering the high-melting point metal. The resultant device is heated so as to alloy wedge polycrystalline silicon portion 16a with the conductor line and/or contact electrode 14b. The heating temperature is approximately 400°C to 500°C in the case of the Al conductor line and is from 900°C to 1000°C in the case of the high-melting point melt conductor line. Contact electrode 14b and the alloy of polycrystalline silicon portion 16a ensure an ohmic contact between conductor line and semiconductor substrate 12. Thus, a semiconductor device having a conductor line free of cracks can be produced.

In the case of the Al conductor line, if a PSG layer is formed on the conductor line and on insulating layer 11 as a passivation film, the alloying is carried out during the formation of PSG by the CVD method.

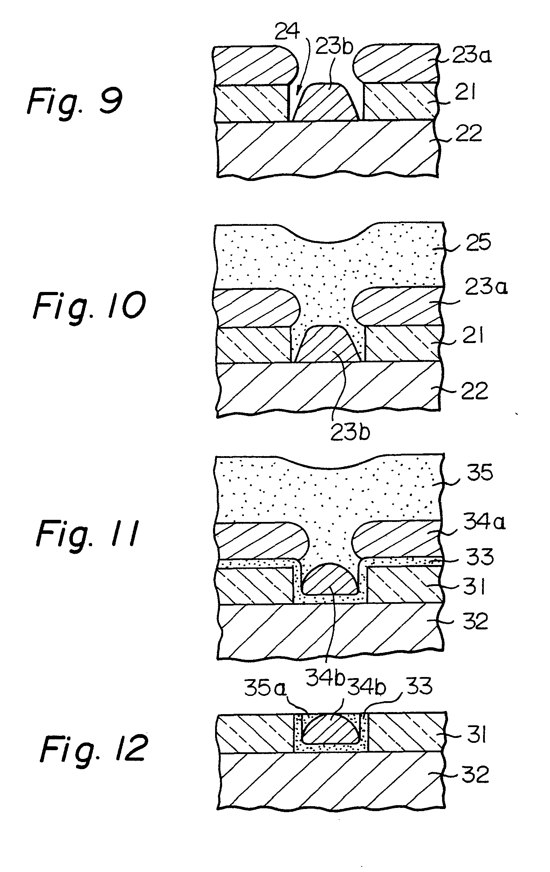

It is possible to produce a semiconductor device in accordance with the second embodiment of the present invention. This process of production will now be explained, referring to Figs. 9 and 10. In Fig. 9, a contact hole is formed in insulating layer 21 lying on semiconductor substrate 22 in the same manner as that of the first embodiment. The photoresist layer (not shown) on insulating layer 21 is removed with a suitable solvent. One of the above-mentioned high-melting point metals is deposited on insulating layer 21 and on the exposed portion of semiconductor substrate 22 by a sputtering method to form metal layer 23a and contact electrode 23b, respectively. Wedge gap 24 is formed between contact electrode 23b and the side of insulating layer 21.

As illustrated in Fig. 10, polycrystalline silicon is deposited on the surfaces of metal layer 23a and contact electrode 23b by a low-pressure CVD method to form polycrystalline silicon layer 25. The wedge gap is filled with polycrystalline silicon layer 25. Then polycrystalline silicon layer 25 and metal layer 23a are etched by a dry etching method so as to expose the surface of insulating layer 21. Thus, the obtained structure having a level surface is the same as that illustrated in Fig. 7.

A conductor line of Al or of one of the above-mentioned high-melting point metals is formed and then a heat treatment for alloying of the portion of polycrystalline silicon layer 25 remaining in the wedge gap with the conductor line and/or contact electrode 23b is carried out in the same manner as that of the first embodiment. As a result, it is possible to produce a semiconductor device having a conductor line free of cracks, the structure of the device being the same as that illustrated in Fig. 8.

It is also possible to produce a semiconductor device in accordance with the third embodiment of the present invention. This process of production will be explained referring to Figs. 11 and 12. In Fig. 11, a contact hole is formed in insulating layer 31 lying on semiconductor substrate 32 in the same manner as that of the first embodiment. The photoresist layer (not shown) on insulating layer 31 is removed with a suitable solvent. Thin polycrystalline silicon layer 33 is formed on the exposed surfaces of insulating layer 31 and semiconductor substrate 32 by a low-pressure CVD method. Preferably, the polycrystalline silicon layer 33 is heavily doped as deposited or by means of thermal impurity diffusion or ion implantation after the deposition. Then one of the above-mentioned high-melting point metals is deposited on thin polycrystalline silicon layer 33 by a sputtering method so that metal layer 34a and contact electrode 34b are formed. Contact electrode 34b is positioned within a blind hole of thin silicon layer 33, and a wedge gap is formed between contact electrode 34b and the vertical surface of thin silicon layer 33. For example, the thicknesses of insulating layer 31, thin polycrystalline silicon layer 33, and metal layer 34a are approximately 800 nm, approximately 100 nm, and from 400 to 700 nm, respectively. Polycrystalline silicon is deposited on the entire exposed surface by a low-pressure CVD method to form polycrystalline silicon layer 35, with which the wedge gap is filled.

Then, as illustrated in Fig. 12, polycrystalline silicon layer 35, metal layer 34a, and thin polycrystalline silicon layer 33 are etched by a dry etching method so as to expose the surface of insulating layer 31. Portion 35a of silicon layer 35 remains in the wedge gap.

A conductor line (not shown) consisting of a high-melting point metal is formed by using a sputtering method and a photoetching method and then a heat treatment for alloying the polycrystalline silicon of wedge portion 35a and remaining thin layer 33 with the high-melting point metal of the conductor line and contact electrode 34b is carried out in the same manner as that of the first embodiment.

In the case where a conductor line is made of Al, it is preferable to perform a heat treatment for alloying the polycrystalline silicon of wedge portion 35a and thin layer 33 with contact electrode 34b prior to the formation of the Al conductor line. The heat-treatment conditions are, for example, a heating temperature of 1000°C and a heating time of ten minutes. After the formation of the Al conductor line, the Al conductor line is subjected to a heat treatment (annealing) at approximately 400°C to 500°C.

Thus, it is possible to produce a semiconductor device having a conductor line free of cracks since the wedge polycrystalline silicon portion ensures the formation of a substantially level surface, as illustrated in Fig. 12.

## Claims

1. A semiconductor device comprising an insulating layer (11) which is formed on a semiconductor substrate (12) or a conductor line and is provided with a contact hole therein; a contact electrode (14b) formed in the contact hole; and a conductor line lying on the contact electrode (14b) and on the insulating layer (11), characterised in that a gap (15) between the contact electrode (14b) and the side of the insulating layer (11) is filled with an alloy of polycrystalline silicon (16a) and at least one of the conductor line lying on the contact electrode and the contact electrode (14b).

2. A semiconductor device according to claim 1, characterised in that the contact electrode (14b) consists of a material selected from the group consisting of molybdenum, tantalum, titanium, tungsten, platinum, and the silicides thereof.

3. A semiconductor device according to claim 1 or claim 2, characterised in that the conductor line lying on the contact electrode consists of a metal selected from the group consisting of aluminium, molybdenum, tantalum, titanium, tungsten, and platinum.

4. A method of producing a semiconductor device comprising the steps of forming an insulating layer (11) on a semiconductor substrate (12) or a conductor line; opening a contact hole in the insulating layer (11); forming a contact electrode (14b) in the contact hole; and forming a conductor line on the contact electrode (14b) and insulating layer (11); characterised in that the method further comprises the steps of filling a gap (15) between the contact electrode (14b) and the side of the insulating layer (11) with polycrystalline silicon (16a) prior to the formaiton of the conductor line; and alloying the polycrystalline silicon (16a) with at least one of the conductor line formed on the contact electrode and the contact electrode (14b), by heating.

5. A method according to claim 4, characterised in that the step of filling the gap (24) with polycrystalline silicon (25) comprises depositing polycrystalline silicon (25) in the gap (24) and on a metal layer (23a) formed on the insulating layer (21) during formation of the contact electrode (23b), and subsequently removing the metal layer (23a) and polycrystalline silicon (25) not filling the gap (24).

6. A method according to claim 4 or claim 5, characterised in that a thin layer (33) of polycrystalline silicon is deposited in the contact hole and on the insulating layer (31) prior to formation of the contact electrode (34b).

7. A method according to any of claims 4 to 6, characterised i that the contact electrode (14b) consists of a material selected from the group consisting of molybdenum, tantalum, titanium, tungsten, platinum and the silicides thereof.

**Revendications**

1. Dispositif semiconducteur comprenant une couche isolante (11) qui est formée sur un substrat semiconducteur (12) ou une ligne conductrice et est dotée d'un tou de contact, une électrode de contact (14b) formée dans le trou de contact, et une ligne conductrice reposant sur l'électrode de contact (14b) et sur la couche isolante (11), caractérisé en ce qu'on remplit un intervalle (15) formé entre l'électrode de contact (14b) et le côté de la couche isolante (11) au moyen d'un alliage de silicium polycristallin (16a) et d'au moins un des matériaux formant la ligne conductrice reposant sur l'électrode de contact et l'électrode de contact (14b).

2. Dispositif semiconducteur selon la revendication 1, caractérisé en ce que l'électrode de contact (14b) est constituée d'un matériau choisi dans le groupe comprenant le molybdène, le tantale, le titane, le tungstène, le platine et leurs siliciures.

3. dispositif semiconducteurs selon la revendication 1 ou 2, caractérisé en ce que la ligne conductrice reposant sur l'électrode de contact est constituée d'un métal choisi dans le groupe comprenant l'aluminium, le molybdène, le tantale, le titane le tungstène et le platine.

4. Procédé de production d'un dispositif semiconducteur comprenant les opérations consistant à former une couche isolante (11) sur un substrat semiconducteur (12) ou une ligne conductrice, à ouvrir un trou de contact dans la couche isolante (11), à former une électrode de contact (14b) dans le trou de contact, et à u former une ligne conductrice sur l'électrode de contact (14b) et la couche isolante (11), caractérisé en ce qu'il comprend un outre les opérations consistant à remplir un intervalle (15) formé entre l'électrode de contact (14b) et le côté de la couche isolante (11) au moyen de silicium polycristallin (16a) avant la formation de la ligne conductrice, et à allier le silicium polycrystallin (16a) avec au moins l'un des matériaux formant la ligne conductrice placée sur l'électrode de contact et l'électrode de contact (14b), par chauffage.

5. Procédé selon la revendication 4, caractérisé en ce que l'opération de remplissage de l'intervalle (24) au moyen de silicium polycristallin (25) consiste à faire déposer du silicium polycristallin (25) dans l'intervalle (24) et sur une couche métallique (23a) formée sur la couche isolante (21) pendant la formation de l'électrode de contact (23b), et à ensuite retirer la couche métallique (23a) et le silicium polycristallin (25) ne remplissant pas l'intervalle (24).

6. Procédé selon la revendication 4 ou 5, caractérisé en ce qu'on fait déposer une mince couche (33) de silicium polycristallin dans le trou de contact et sur la couche isolante (31) avant la formation de l'électrode de contact (34b).

7. Procédé selon l'une quelconque des revendications 4 à 6, caractérisé en ce que l'électrode de contact (14b) consiste en un matériau choisi dans le groupe comprenant le molybdène, le tantale, le titane, le tungstène, le platine et leurs siliciures.

**Patentansprüche**

1. Halbleitervorrichtung mit einer isolierenden Schicht (11), welche auf einem Halbleitersubstrat (12) oder einem Leiterband gebildet ist und ein Kontaktloch enthält; einer Kontaktelektrode (14b), die in dem Kontaktloch gebildet ist; und einem Leiterband, das auf der Kontaktelektrode (14b) und auf der isolierenden Schicht (11) liegt, dadurch gekennzeichnet, daß ein Spalt (15) zwischen der Kontaktelektrode (14b) und der Seite der isolierenden Schicht (11) mit einer Legierung aus polykristallinem Silizium (16a) gefüllt ist, und wenigstens einem Leiterband, das auf der Kontaktelektrode liegt, und der Kontaktelektrode (14b).

2. Halbleitervorrichtung nach Anspruch 1, dadurch gekennzeichnet, daß die Kontaktelektrode (14b) aus einem Material besteht, ausgewählt aus der Gruppe bestehend aus Molybdän Tantal, Titan, Wolfram, Platin und den Siliziden davon.

3. Halbleitervorrichtung nach Anspruch 1 oder 2, dadurch gekennzeichnet, daß das Leiterband, das auf der Kontaktelektrode liegt, aus einem Metall besteht, das ausgewält ist aus der Gruppe bestehend aus Aluminium, Molybdän, Tantal, Titan, Wolfram und Platin.

4. Verfahren zur Herstellung einer Halbleitervorrichtung mit den Schritten der Bildung einer isolierenden Schicht (11) auf einem Halbleitersubstrat oder einem Leiterband; Öffnen eines Kontaktloches in der isolierenden Schicht (11); Bildung einer Kontaktelektrode (14b) in dem Kontaktloch; und Bildung eines Leiterbandes auf der Kontaktelektrode (14b) und der isolierenden Schicht (11); dadurch gekennzeichnet, daß das Verfahren ferner die Schritte der Ausfüllung eines Spaltes (15) zwischen der Kontaktelektrode (14b) und der Seite der isolierenden Schicht (11) mit polykristallinem Silizium (16a) vor der Bildung des Leiterbandes umfaßt; und Legieren des polykristallinen Siliziums (16a), mit wenigstens einem auf der Kontaktelektrode gebildeten Leiterband und der Kontaktelektrode (14b) durch Erhitzen.

5. Verfahren nach Anspruch 4, dadurch gekennzeichnet, daß der Schritt des Ausfüllens des Spaltes (24) mit polykristallinem Silizium (25) die Niederschlagung von polykristallinem Silizium (25) in dem Spalt (24) und auf einer Metallschicht (23a) umfaßt, die auf der isolierenden Schicht (21) während der Bildung der Kontaktelektrode (23b) gebildet wird, und die anschließende Entfernung der Metallschicht (23a) und des polykristallinen Siliziums (25), welches den Spalt (24) nicht füllt.

6. Verfahren nach Anspruch 4 oder 5, dadurch gekennzeichnet, daß eine dünne Schicht (33) aus polykristallinem Silizium vor der Bildung der Kontaktelektrode (34) in dem Kontaktloch und auf der isolierenden Schicht (31) niedergeschlagen wird.

7. Verfahren nach einem der Ansprüche 4 bis 6, dadurch gekennzeichnet, daß die Kontaktelektrode (14b) aus einem Material besteht, das ausgewählt ist aus der Gruppe bestehend aus Molybdän, Tantal, Titan, Wolfram, Platin und den Siliziden von diesen.

*Fig. 1*

*Fig. 2*

*Fig. 3*

*Fig. 4*

1

*Fig. 5*

*Fig. 6*

*Fig. 7*

*Fig. 8*

*Fig. 9*

*Fig. 10*

*Fig. 11*

*Fig. 12*